Europäisches Patentamt

European Patent Office

Office européen des brevets

(19)

(11) Veröffentlichungsnummer: **0 212 156 B1**

(12) **EUROPÄISCHE PATENTSCHRIFT**

(45) Veröffentlichungstag der Patentschrift: 17.07.91

(51) Int. Cl.5: **G01D 1/18, G01K 3/00**

(21) Anmeldenummer: 86108868.0

(22) Anmeldetag: 30.06.86

(54) **Messschaltungsanordnung für einen elektrischen Messwertgeber.**

(30) Priorität: 12.07.85 DE 3524886

(43) Veröffentlichungstag der Anmeldung:
04.03.87 Patentblatt 87/10

(45) Bekanntmachung des Hinweises auf die
Patenterteilung:
17.07.91 Patentblatt 91/29

(84) Benannte Vertragsstaaten:
DE FR GB IT

(56) Entgegenhaltungen:
DE-A- 2 452 529
GB-A- 1 578 535
US-A- 3 390 332
US-A- 3 927 571

(73) Patentinhaber: **VDO Adolf Schindling AG**
**Gräfstrasse 103**
**W-6000 Frankfurt/Main 90(DE)**

(72) Erfinder: **Von Pentz, Bernhard**
**Ludwig-Christ-Strasse 9**
**W-6242 Kronberg(DE)**

(74) Vertreter: **Klein, Thomas, Dipl.-Ing. (FH)**
**Sodener Strasse 9 Postfach 6140**
**W-6231 Schwalbach a. Ts.(DE)**

## Beschreibung

Die Erfindung betrifft eine Meßschaltungsanordnung für einen elektrischen Meßwertgeber nach dem Oberbegriff des Anspruchs 1.

Eine derartige Meßschaltungsanordnung ist aus der GB-A 1 578 535 bekannt.

In bekannnten Meßschaltungsanordnungen ist ein Meßwertgeber, insbesondere ein NTC-Widerstand, zu einem Anzeigeinstrument in Reihe geschaltet an eine Betriebsspannungsquelle angeschlossen. Der NTC-Widerstand verursacht einen entsprechend der Umgebungstemperatur des NTC-Widerstands variablen Strom durch das Anzeigeinstrument, und zwar einen relativ großen Strom, wenn die Temperatur hoch ist. Mit dem Anzeigeinstrument erfolgt eine von dem Strom bzw. von der Geberspannung an dem NTC-Widerstand abhängige Anzeige als Zeigerausschlag.

Wenn durch die Anwendung dieses Meßwertgebers und des Anzeigeinstruments die Kühlwassertemperatur eines Kraftfahrzeugverbrennungsmotors überwacht werden soll, kann es erwünscht sein, kurzfristige Schwankungen der Kühlwassertemperatur im Fahrbetrieb nicht anzuzeigen, da diese auch bei störungsfreiem Betrieb des Kraftfahrzeugverbrennungsmotors auftreten und den Fahrer ohne Grund irritieren können. Andererseits soll der Fahrer möglichst bald durch einen großen Zeigerausschlag gewarnt werden, wenn die Kühlwassertemperatur Werte annimmt, die eine Beschädigung des Kraftfahrzeugverbrennungsmotors befürchten lassen.

Um unerwünschte Schwankungen der Anzeige des Anzeigeinstruments abzuschwächen, kann daran gedacht werden, eine verhältnismäßig große Dämpfung des Anzeigeinstruments selbst oder in der Meßschaltungsanordnung, in der das Anzeigeinstrument angeordnet ist, vorzusehen. Beispielsweise weisen die üblicherweise zur Kühlwassertemperaturüberwachung verwendeten Bimetallanzeigeinstrumente bereits eine nennenswerte Dämpfung auf, die jedoch noch nicht ausreicht, um die beschriebenen starken kurzfristigen Schwankungen in einem normalen Temperaturbereich genügend stark zu unterdrücken. Wenn die Dämpfung verstärkt werden soll, kann dies nicht nur einen erhöhten Aufwand für Energiespeicher in der Meßschaltungsanordnung verursachen, sondern vor allem auch dann einen stark verzögerten Zeigerausschlag bewirken, wenn es darauf ankommt, unzulässig hohe Kühlwassertemperaturen rasch und deutlich anzuzeigen.

Der vorliegenden Erfindung liegt daher die Aufgabe zugrunde, eine Meßschaltungsanordnung der eingangs beschriebenen Gattung so weiterzubilden, daß in einem mittleren Teilmeßbereich eine möglichst vollständige Unterdrückung von Anzeigeschwankungen erfolgt, während in einem unteren Teilmeßbereich und insbesondere in einem oberen Teilmeßbereich, in dem die Meßwerte bedenkliche Werte annehmen, eine weitgehend ungedämpfte Anzeige erfolgt. Insbesondere bei der Anwendung der Meßschaltungsanordnung zur Kühlwassertemperaturüberwachung von Kraftfahrzeugverbrennungsmotoren soll also der Fahrer möglichst unmittelbar darüber unterrichtet werden, daß die Kühlwassertemperatur von zu niedrigen Werten in einen normalen mittleren Teilmeßbereich einläuft, und vor allem soll eine deutliche Warnung erfolgen, wenn der mittlere Teilmeßbereich verlassen wird, weil die Kühlwassertemperatur zu hohe Werte annimmt.

Diese Aufgabe wird durch die Ausbildung der gattungsgemäßen Meßschaltungsanordnung mit den in dem kennzeichnenden Teil des Anspruchs 1 angegebenen Merkmalen gelöst.

Erfindungsgemäß wird also keine weitere Verzögerung und verstärkte Mittelwertbildung der Geberspannung oder einer dieser Geberspannung nachgeführten Spannung vorgesehen, die eine trägere Anzeige hervorrufen würde. Vielmehr unterdrückt die Meßschaltungsanordnung in dem mittleren Teil-Meßbereich die Anzeige des aktuellen Meßwerts und der ihm entsprechenden Spannung und bewirkt statt dessen einen konstanten Zeigerausschlag. Dieser entspricht dem Meßwert bei der ersten Grenz-Geberspannung, bei der der untere Teil-Meßbereich in den mittleren Teil-Meßbereich übergeht. Von dem weiteren zeitlichen Verlauf der Geberspannung ist dann die Anzeige in dem mittleren Teil-Meßbereich unabhängig. Der Beobachter des Anzeigeinstruments stellt also in dem mittleren Teil-Meßbereich lediglich fest, daß der überwachte Betriebszustand in Ordnung ist und macht sich keine unnötigen Gedanken über belanglose Schwankungen. Erst wenn der Meßwert den oberen Teil-Meßbereich erreicht, und zwar wenn die zweite Grenz-Geberspannung erreicht wird, erfolgt wieder eine Anzeige der aktuellen Meßwerte. Da diese Anzeige ohne zusätzliche Verzögerung erfolgt, kann der Beobachter des Anzeigeinstruments zuverlässig gewarnt werden und über den kritischen Meßwertverlauf unterrichtet gehalten werden. Eine zusätzliche augenfällige Warnung tritt dadurch ein, daß die Anzeige beim Passieren der zweiten Grenz-Geberspannung sprunghaft den neuen Wert in dem oberen Teil-Meßwertbereich anzeigt, also eine deutlich sichtbare Veränderung der Anzeige bewirkt wird. Es wird daher auch ein wenig aufmerksamer oder abgelenkter Beobachter zuverlässig gewarnt.

Bei der Verwendung der Meßschaltungsanordnung zur Kühlwassertemperaturüberwachung kann der mittlere Teil-Meßbereich sich vorteilhaft von etwa 80° C bis 105° C erstrecken. Bei 80° C tritt also die erste Grenz-Geberspannung auf und bei 105° C die zweite Grenz-Geberspannung. Bei der Verwendung eines NTC-Widerstands als Meßgeber ist somit die erste Grenz-Geberspannung relativ groß und die zweite Grenz-Geberspannung relativ klein. Dem entsprechen umgekehrt eine relativ kleine nachgeführte Spannung bzw. eine relativ große nachgeführte Spannung an dem Anzeigeinstrument, da der NTC-Widerstand in Reihe zu einem Ersatzwiderstand-gleich dem Widerstand des Anzeigeinstruments-liegend an die Betriebsspannungsquelle angeschlossen ist.

Ein Vorteil der erfindungsgemäßen Schaltungsanordnung besteht auch darin, daß keine aufwendigen Speicher zur Mittelwertbildung der Geberspannung vorzusehen sind.

Die Meßschaltungsanordnung kann wenig aufwendig mit drei Komparatoren nach Anspruch 2 aufgebaut werden. Dabei dient die Geberspannung zur Ansteuerung des ersten Komparators, um mit diesem über einen nachgeschalteten Transistor einen Spannungsabfall in Reihe zu dem Anzeigeinstrument zu erzeugen, der gleich der Geberspannung ist. Dieser Spannungsabfall stellt also eine der Geberspannung nachgeführte Spannung dar. Der zweite Komparator bildet die Klemmspannung, wenn eine erste vorgegebene Grenz-Geberspannung überschritten wird. Mit dem dritten Komparator wird beim Überschreiten einer zweiten Grenz-Geberspannung der zweite Komparator unwirksam geschaltet, so daß die Klemmspannung entfällt und der erste Komparator wieder eine der Geberspannung nachgeführte Spannung erzeugt.

Mit dieser Schaltungsanordnung, zu der weitere vorteilhafte Einzelheiten in Anspruch 3 angegeben sind, kann der mittlere Teil-Meßbereich, in dem die Anzeige entsprechend der Klemmspannung konstant gehalten wird, weitgehend unabhängig von Schwankungen der Umgebungstemperatur exakt festgelegt werden. Die vorgesehenen Dioden dienen zur Entkopplung des zweiten Komparators und des dritten Komparators von dem ersten bzw. zweiten Komparator, bestimmen aber nicht die Grenzen des mittleren Teil-Meßbereichs.

Die Grenzen des mittleren Teil-Meßbereichs werden vielmehr durch die Referenzspannung bzw. die Vergleichsspannung festgelegt, die in unkomplizierter Weise nach Anspruch 5 erzeugt werden.

Indem der Ersatzwiderstand in der Reihenschaltung mit dem Meßwertgeber von dem Widerstandswert des Anzeigeinstruments, den er in der Reihenschaltung ersetzen soll, abweicht, kann die nachgeführte Spannung gegenüber der Geberspannung um einen konstanten Faktor verändert werden. Die Wahl des Ersatzwiderstands läßt also eine Einstellung der Anzeige außerhalb des mittleren Teil-Meßbereichs zu, indem die Anzeige konstant ist.

Die Erfindung wird im folgenden anhand einer Zeichnung mit zwei Figuren erläutert. Es zeigen:

Figur 1    ein Schaltbild der Meßschaltungsanordnung und

Figur 2    die mit der Schaltungsanordnung erzielte Anzeigecharakteristik des Anzeigeinstruments, nämlich des Skalenwinkels in Abhängigkeit von der Temperatur, die mit einem NTC-Widerstand erfaßt wird.

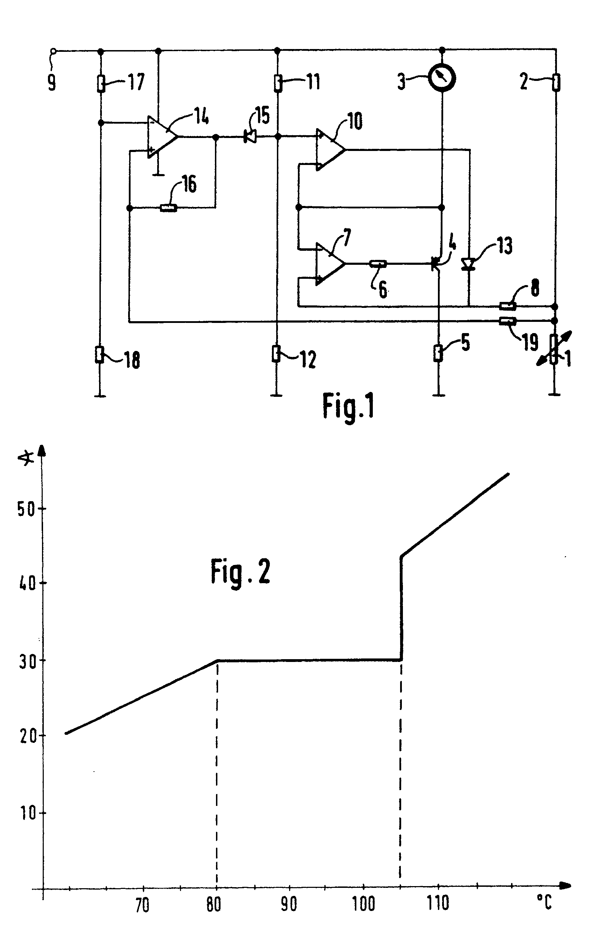

In der Schaltungsanordnung in Figur 1 ist der NTC-Widerstand, der zur Kühlwassertemperaturmessung vorgesehen ist, mit 1 bezeichnet. Er stellt den Meßgeber dar und liegt in Reihe zu einem Ersatzwiderstand 2 eines Anzeigeinstruments 3. Das Anzeigeinstrument ist als Bimetallanzeigeinstrument ausgebildet.

In Reihe zu dem Anzeigeinstrument 3 ist eine Emitter-Kollektorstrecke eines Transistors 4 angeordnet, zu der wiederum ein Vorwiderstand 5 in Serie geschaltet ist. Der Vorwiderstand bewirkt u.a. einen Schutz des Transistors 4 und des Anzeigeinstruments 3, wenn an dem NTC-Widerstand oder dessen Zuleitungen ein Kurzschluß auftritt.

Die Basis des Transistors 4 wird über einen Koppelwiderstand 6 von einem Ausgang eines ersten Differenzverstärkers 7 angesteuert. Ein + Eingang des Differenzverstärkers 7 steht über einen Entkopplungswiderstand 8 mit dem NTC-Widerstand 1 in Verbindung. Ein -Eingang ist direkt an den Emitter des Transistors 4 angeschlossen.

Die Schaltungsanordnung wird durch eine Betriebsspannungsquelle gespeist, die an einer Klemme 9 sowie an einer Masseverbindung anliegt.

Der bisher beschriebene Schaltungsteil mit dem ersten Differenzverstärker wirkt in der Weise, daß der Geberspannung an dem NTC-Widerstand die Spannung nachgeführt wird, die an dem Emitter des Transistors gegenüber Masse abfällt. Wenn der Ersatzwiderstand 2 gleich dem Innenwiderstand des Anzeigeinstruments 3 gewählt ist, fließt daher durch das Anzeigeinstrument ein gleichhoher Strom wie durch den Ersatzwiderstand und den NTC-Widerstand. Das bedeutet, daß in diesem betrachteten ersten Teil-Meßbereich, der in Figur 2 bis 80° C verläuft, der Zeigerausschlag in gleicher Weise erfolgt, als ob das Anzeigeinstrument in üblicher Weise in Reihe zu dem NTC-Widerstand geschaltet ist.

Oberhalb dieser Temperatur von 80° C wird jedoch mit einem zweiten Differenzverstärker 10 in den zuvor beschriebenen Schaltungsteil eingegriffen:

Der zweite Differenzverstärker erhält normalerweise an seinem + Eingang eine Referenzspannung, die dem Teilerverhältnis der in Reihe geschalteten Widerstände 11 und 12 entspricht. An einem -Eingang des zweiten Differenzverstärkers liegt die von dem ersten Differenzverstärker 7 und dem Transistor 4 erzeugte nachgeführte Spannung.

Das Teilerverhältnis der Widerstände 11 und 12 ist so eingestellt, daß die Spannung an dem +Eingang des zweiten Differenzverstärkers 10 gleich der nachgeführten Spannung an dem Emitter des Transistors 4 ist, wenn die Temperatur von 80° C an dem NTC-Widerstand 1 erreicht und überschritten wird. Beim Überschreiten dieser Temperatur wird die nachgeführte Spannung an dem -Eingang des zweiten Differenzverstärkers kleiner als die Referenzspannung an dessen +Eingang. Die Ausgangsspannung des zweiten Differenzverstärkers 10 wird über eine jetzt in Durchflußrichtung beanspruchte Diode 13 dem +Eingang des ersten Differenzverstärkers 7 aufgedrückt. Dies bedeutet, daß diese Klemmspannung an dem +Eingang eine entsprechend nachgeführte Spannung an dem Anzeigeinstrument erzeugt, solange die Geberspannung an dem NTC-Widerstand 1 kleiner als die Referenzspannung an dem +Eingang des zweiten Differenzverstärkers ist und solange kein noch zu beschreibender zusätzlicher Schaltungsteil wirksam wird. Diese Bedingungen sind in dem mittleren Teilmeßbereich zwischen 80° C und 105° C in Figur 2 erfüllt, die demgemäß eine konstante Anzeige in diesem Teil-Meßbereich darstellt.

Überschreitet die Temperatur in dem NTC-Widerstand 1 105° C, so wird ein weiterer Teil der Meßschaltungsanordung aktiviert: Dieser Teil umfaßt im wesentlichen einen dritten Differenzverstärker 14, dessen Ausgang über eine zweite Diode 15 ebenfalls mit dem +Eingang des zweiten Differenzverstärkers verbunden ist. Außerdem ist der Ausgang über einen Widerstand 16 zu dem +Eingang dieses dritten Differenzverstärkers rückgekoppelt. Ein Spannungsteiler mit Widerständen 17, 18 erzeugt durch Unterteilung der Betriebsspannung eine Vergleichsspannung an einem -Eingang des dritten Differenzverstärkers 14. Der +Eingang dieses Differenzverstärkers wird über einen zweiten Entkopplungswiderstand 19 mit der Geberspannung an dem NTC-Widerstand 1 beaufschlagt - auch wenn die Klemmspannung auf den Schaltungsteil mit dem ersten Differenzverstärker einwirkt.

Bei einer Geberspannung, die bei Temperaturen unter 105° C gegenüber der Vergleichsspannung an dem -Eingang des dritten Differenzverstärkers 14 verhältnismäßig groß ist, entsteht an dem Ausgang dieses Differenzverstärkers ein hohes Potential, durch welches die Diode 15 sperrt. Die Schaltungsanordnung mit dem ersten Differenzverstärker und mit dem zweiten Differenzverstärker arbeitet also wie oben beschrieben unbeeinflußt von dem dritten Differenzverstärker.

Sobald jedoch die Temperatur in dem NTC-Widerstand 105° C überschreitet und dementsprechend die Geberspannung unter die Vergleichsspannung sinkt, wird das Potential an dem Ausgang des dritten Differenzverstärkers annähernd Null und die Diode 15 leitet, dabei das Potential an dem +Eingang des zweiten Differenzverstärkers 10 ebenfalls auf annähernd Null ziehend. Dadurch sinkt das Potential an dem Ausgang des zweiten Differenzverstärkers so ab, daß die Diode 13 sperrt, d.h. die Klemmspannung verschwindet. Der Schaltungsteil mit dem ersten Differenzverstärker 9 arbeitet wieder unbeeinflußt wie eingangs beschrieben. Dies bedeutet, daß die Spannung an dem Anzeigeinstrument sprunghaft auf den Wert steigt, auf den sie der Geberspannung nachgeführt wird, wenn keine Klemmschaltung vorhanden wäre. Darüber hinaus erfolgt die Nachführung der Spannung an dem Anzeigeinstrument in einer von der Klemmschaltung unbeeinflußten Weise, solange sich die Temperatur in dem oberen Teil-Meßbereich oberhalb 105° C bewegt.

## Patentansprüche

1. Meßschaltungsanordnung für einen elektrischen Meßwertgeber und ein Anzeigeinstrument, welches eine von einer Geberspannung des Meßwertgebers abhängige Anzeige hat, mit Mitteln zum Unterdrücken von Anzeigeschwankungen in einem mittleren Teil-Meßbereich des Anzeigeinstruments, insbesondere zur Kühlwassertemperaturüberwachung von Kraftfahrzeugverbrennungsmotoren mit einem Bimetallanzeigeinstrument und einem NTC-Widerstand als Meßwertgeber, wobei die Meßschaltungsanordnung eine Klemmschaltung (10 - 19) aufweist, die das Anzeigeinstrument (3) in einem unteren Teil-Meßbereich (z.B. bis 80° C) bis zu einer ersten Grenz-Geberspannung mit einer in Abhängigkeit von der Geberspannung nachgeführten Spannung beaufschlagen läßt, die das Anzeigeinstrument in einem mittleren Teil- Meßbereich (z.B. bis 80° C bis 105° C) zwischen der ersten Grenz-Geberspannung und einer zweiten Grenz-Geberspannung mit einer konstanten Spannung (Klemmspannung) speist, und die das Anzeigeinstrument in einem oberen Teil-Meßbereich (z.B. über 105° C) mit einer in Abhängigkeit von der Geberspannung nachgeführten Spannung beaufschlagen läßt, wobei sich die Spannung an dem Anzeigeinstrument sprunghaft ändert, wenn die zweite Grenz-Geberspannung (z.B. bei 105° C) überschritten wird, dadurch gekennzeichnet, daß die konstante Spannung am Anzeigeinstrument im mittleren Teil-Meßbereich gleich der bei der ersten Grenz-Geberspannung an dem Anzeigeinstrument liegenden Spannung ist.

2. Meßschaltungsanordnung nach Anspruch 1, **dadurch gekennzeichnet,** daß ein erster Komparator (Differenzverstärker 7) vorgesehen ist, in dem die Geberspannung mit der nachgeführten Spannung verglichen wird, die an einem gesteuerten Halbleiter Bauelement (Transistor 4) zu einem festen Bezugspotential (Massepotential) auftritt, daß die Klemmschaltung (10 - 19) einen zweiten Komparator (zweiter Differenzverstärker 10) umfaßt, in dem die Geberspannung mit einer auf die erste Grenz-Geberspannung eingestellten Referenzspannung verglichen wird und der den ersten Komparator (erster Differenzverstärker 7) mit einer innerhalb des mittleren Teil-Meßbereichs auf den Wert der ersten Grenz-Meßspannung festgehaltenen Klemmspannung anstatt der Geberspannung beaufschlagt,und daß ein dritter Komparator (Differenzverstärker 14) ebenfalls Teil der Klemmschaltung ist, in dem die Geberspannung mit einer auf die zweite Grenz-Meßspannung eingestellten Vergleichsspannung verglichen wird und der in dem oberen Teil-Meßbereich die Klemmspannung von dem ersten Komparator (erster Differenzverstärker 7) abschaltet.

3. Meßschaltungsanordnung nach Anspruch 2, **dadurch gekennzeichnet,** daß ein Eingang des ersten Komparators (erster Differenzverstärker 7) mit der Geberspannung über einen Entkopplungswiderstand (8) beaufschlagt wird und zur Aufschaltung der Klemmspannung über eine erste Diode (13) mit einem Ausgang des zweiten Komparators (zweiter Differenzverstärker 10) gekoppelt ist und daß der mit der Referenzspannung beaufschlagte Eingang des zweiten Komparators (zweiter Differenzverstärker 10) über eine zweite Diode (15) mit einem Ausgang des dritten Komparators (dritter Differenzverstärker 14) zur Abschaltung der Klemmspannung von dem ersten Komparator (erster Differenzverstärker 7) gekoppelt ist.

4. Schaltungsanordnung nach einem der Ansprüche 1 - 3, **dadurch gekennzeichnet,** daß jeder Komparator einen Differenzverstärker (7 bzw. 10 bzw. 14) aufweist.

5. Meßschaltungsanordnung nach einem der Ansprüche 1 - 4, **dadurch gekennzeichnet,** daß die Referenzspannung an einem Eingang des zweiten Komparators (zweiter Differenzverstärker 10) und die Vergleichsspannung an einem Eingang des dritten Komparators (dritter Differenzverstärker 14) durch je einen Spannungsteiler (11, 12 bzw. 17, 18) gebildet werden.

6. Meßschaltungsanordnung nach einem der vorangehenden Ansprüche, **dadurch gekennzeichnet,** daß der Meßwertgeber (NTC-Widerstand 1) in Reihe zu einem Ersatzwiderstand (2) geschaltet ist, dessen Widerstandswert zur Einstellung der Anzeigecharakteristik gleich dem Innenwiderstand des Anzeigeinstruments (3) oder davon abweichend gewählt ist.

## Claims

1. Measuring circuit arrangement for an electrical measurement value signal emitter and an indicator instrument which gives an indication dependent on a signal emitter voltage of the measurement value signal emitter, with means for the suppression of indication fluctuations in a central partial measuring range of the indicator instrument, especially for monitoring the cooling water temperature of motor vehicle internal combustion engines, with a bimetallic indicator instrument and an NTC resistor as measurement value signal emitter, the measuring circuit arrangement having a clamping circuit (10 - 19) which in a lower partial measuring range (e.g. up to 80° C) up to a first critical signal emitter voltage causes the indicator instrument (3) to be acted upon with a voltage followed up in dependence on the signal emitter voltage, which in a central partial measuring range (e.g. between 80° C and 105° C) between the first critical signal emitter voltage and a second critical signal emitter voltage supplies the indicator instrument with a constant voltage (clamp voltage), and which in an upper partial measuring range (e.g. above 105° C) causes the indicator instrument to be acted upon with a voltage followed up in dependence on the signal emitter voltage, the voltage at the indicator instrument changing suddenly when the second critical signal emitter voltage (e.g. at 105° C) is exceeded, characterised in that the constant voltage at the indicator instrument in the central partial measuring range is equal to the voltage present at the indicator instrument at the first critical signal emitter voltage.

2. Measuring circuit arrangement according to claim 1, characterised in that a first comparator (differential amplifier 7) is provided wherein the signal emitter voltage is compared with the followed-up voltage which occurs at a controlled semiconductor element (transistor 4) relatively to a fixed reference potential (earth potential), that the clamping circuit (10 - 19) comprises a second comparator (second differential amplifier 10) in which the signal emitter voltage is compared with a reference voltage adjusted to the first critical signal emitter voltage and which acts upon the first comparator (first differential amplifier 7) with a clamp voltage, held fast to the value of the first critical measuring voltage within the central partial measuring range, instead of with the signal emitter voltage, and that a third comparator (differential amplifier 14) is also a part of the clamping circuit, in which the signal emitter voltage is compared with a comparison voltage adjusted to the second critical measuring voltage and which in the upper partial measuring range disconnects the clamp voltage from the first comparator (first difderential amplifier 7).

3. Measuring circuit arrangement according to claim 2, characterised in that an input of the first comparator (first differential amplifier 7) is acted upon with the signal emitter voltage through a decoupling resistor (8) and is coupled for switching-on the clamp voltage through a first diode (13) with an output of the second comparator (second differential amplifier 10), and that that input of the second comparator (second differential amplifier 10) which is acted upon with the reference voltage is coupled via a second diode (15) with an output of the third comparator (third differential amplifier 14) for switching-off the clamp voltage from the first comparator (first differential amplifier 7).

4. Circuit arrangement according to one of claims 1 - 3, characterised in that each comparator has a differential amplifier (7, 10, 14 respectively).

5. Measuring circuit arrangement according to one of claims 1 - 4, characterised in that the reference voltage is formed at an input of the second comparator (second differential amplifier 10) and the comparison voltage is formed at an input of the third comparator (third differential amplifier 14) by in each case a respective voltage divider (11, 12 and 17, 18).

6. Measuring circuit arrangement according to one of the preceding claims, characterised in that the measurement value signal emitter (NTC resistor 1) is connected in series with an equivalent resistor (2), whose resistance value is selected to be equal to, or deviating from, the internal resistance of the indicator instrument (3) for the purpose of adjusting the indication characteristic.

**Revendications**

1. Montage de circuit de mesure pour un capteur électrique de valeur de mesure et pour un indicateur dont l'indication est fonction d'une tension du capteur de valeur de mesure, montage comportant des moyens pour supprimer les variations d'indication sur une plage partielle médiane de mesure de l'indicateur, en particulier pour la surveillance de la température de l'eau de refroidissement de moteurs à combustion interne pour véhicules, montage comportant un indicateur bimétallique et ayant, comme capteur de valeur de mesure, une résistance à coefficient de température négatif CTN, étant précisé que le montage de circuit de mesure présente un circuit d'arrêt (10-19) qui, sur une plage partielle inférieure de mesure (par exemple jusqu'à 80 °C), jusqu'à une première tension limite du capteur, peut soumettre l'indicateur à une tension fonction de la tension du capteur, circuit qui, dans une plage partielle médiane de mesure (par exemple de 80 °C à 105 °C), entre la première tension limite du capteur et une seconde tension limite du capteur, envoie à l'indicateur une tension constante (tension d'arrêt) et circuit qui, sur une plage partielle supérieure de mesure (par exemple au-dessus de 105 °C), peut soumettre l'indicateur à une tension fonction de la tension du capteur, étant précisé que la tension arrivant à l'indicateur se modifie brusquement lorsque l'on dépasse la seconde tension limite du capteur (par exemple à 105 °C), montage caractérisé par le fait que la tension constante arrivant à l'indicateur, sur la plage partielle médiane de mesure, est égale à la tension arrivant à l'indicateur au moment où la tension au capteur est la première tension limite du capteur.

2. Montage du circuit de mesure selon la revendication 1,
caractérisé
par le fait qu'il est prévu un premier comparateur (amplificateur différentiel (7)),dans lequel on compare la tension du capteur avec la tension résultante qui apparaît à un composant semi-conducteur commandé (transistor 4)) par rapport à un potentiel de référence fixe (potentiel de masse) ; par le fait que le circuit d'arrêt (10-19) comporte un second comparateur (second amplificateur différentiel (10)), dans lequel on compare la tension du capteur avec une tension de référence réglée sur la première tension limite du capteur et qui, au lieu de la tension du capteur, soumet le premier comparateur (premier amplificateur différentiel 7) à une tension d'arrêt fixée, à l'intérieur de la plage partielle médiane de mesure, sur la valeur de la première tension limite de mesure ; et par le fait que fait également partie du circuit d'arrêt un troisième comparateur (amplificateur différentiel (14)), dans lequel on compare la tension du capteur avec une tension de comparaison réglée sur la seconde tension limite du capteur et qui, sur la plage partielle supérieure de mesure, élimine du premier comparateur (premier amplificateur différentiel 7) la tension d'arrêt.

3. Montage du circuit de mesure selon la revendication 2,

    caractérisé

    par le fait qu'une entrée du premier comparateur (premier amplificateur différentiel (7)) est soumise à la tension du capteur par l'intermédiaire d'une résistance (8) de découplage et que, pour la mise en oeuvre de la tension d'arrêt, cette entrée est couplée, par l'intermédiaire d'une première diode (13), avec une sortie du second comparateur (second amplificateur différentiel (10)), et par le fait que l'entrée du second comparateur (second amplificateur différentiel (10)) soumise à la tension de référence est, pour éliminer du premier comparateur (premier amplificateur différentiel (7)) la tension d'arrêt, couplée, par l'intermédiaire d'une seconde diode (15), avec une sortie du troisième comparateur (troisième amplificateur différentiel (14)).

4. Montage de circuit de mesure selon l'une des revendications 1 à 3,

    caractérisé

    par le fait que chaque comparateur présente un amplificateur différentiel (7 ou 10 ou 14).

5. Montage de circuit de mesure selon l'une des revendications 1 à 4,

    caractérisé par le fait que la tension de référence à une entrée du second comparateur (second amplificateur différentiel (10)) et la tension de comparaison à une entrée du troisième comparateur (troisième amplificateur différentiel (14)) sont formées par, chacune, un diviseur de tension (11, 12 ou 17, 18).

6. Montage de circuit de mesure selon l'une des revendications précédentes,

    caractérisé

    par le fait que le capteur de valeur de mesure (résistance (1) à coefficient de température négatif, CTN) est monté en série avec une résistance équivalente (2) dont, pour régler la caractéristique de l'indicateur, on choisit la valeur égale à la résistance intérieure de l'indicateur (3) ou s'en éloignant.

Fig.1

Fig. 2